# FASCICULE DE BREVET EUROPEEN

(11) **EP 0 858 255 B1**
(45) Date de publication et mention de la délivrance du brevet: **20.04.2005**
(21) Numéro de dépôt: 98500028.0
(22) Date de dépôt: 04.02.1998
(51) Int. Cl.: H05K 13/04

(54) **Construction de têtes d'insertion de languettes, douilles et similaires**
Laschen- und Buchsenbestückungskopf
Insertion head for tonques or sockets

(30) Priorité: 07.02.1997 ES 9700250
(43) Date de publication de la demande: 12.08.1998
(73) Titulaire: MECANISMOS AUXILIARES INDUSTRIALES S.A. M.A.I.S.A., E-43800 Valls, Tarragona (ES); Construcciones Mecanicas Jose Lazpiur, S.A., 43800 Valls, Tarragona (ES)
(72) Inventeur: Altes Puig, Josep, 43800 Valls (Tarragona) (ES); Lazpiur Lamariano, Miguel, 43800 Valls (Tarragona) (ES)
(74) Mandataire: Primo de Rivera y Urquijo, Jose Antonio

(56) Documents cités:
- EP-A- 0 570 280
- ES-A- 2 024 868
- US-A- 4 205 772
- US-A- 4 905 368

## Description

La présente sollicitude de patente d'invention consiste, conformément aux indications de l'énoncé, en la "CONSTRUCTION DE TÊTES D'INSERTION DE LANGUETTES, DOUILLES ET SIMILAIRES", dont les nouvelles caractéristiques de construction, conformation et conception remplissent la mission pour laquelle ils ont été spécifiquement projetés, avec un maximum de sécurité et d'efficacité.

Il existe sur le marché, et ils peuvent donc être considérés comme un état de la technique, une grande diversité de types de machines à insérer dont les caractéristiques essentielles sont de monter, sur un banc conventionnel, une série d'éléments capables de déplacer une table de coordonnées, en immobilisant sur celle-ci un plateau giratoire et ce dernier sur un circuit imprimé, dans la partie supérieure desdites machines on pose un support en cou de cygne duquel pend par les moyens appropriés une tête d'insertion.

La fonction de ces machines est de séparer les languettes, douilles et pièces similaires d'un patenôtre alimenté par une bobine et par les moyens appropriés procéder à la découpe de ce patenôtre en des composants unitaires et procéder à leur insertion ultérieure dans le circuit imprimé sur trois points spécifiques de celui-ci. L'un des éléments d'une importance primordiale sur ce type de machines est celui de la tête d'insertion, tant il est vrai qu'il exécute la principale fonction de la machine, l'insertion, tout cela à partir dudit patenôtre de douilles, languettes et similaires.

Sur la patente nº ES-A-2 024 868, il est fait mention d'une tête automatique pour l'insertion de languettes en plaques de circuit imprimé, lequel obtient, suivant une formule conventionnelle, son alimentation à partir de l'utilisation d'un patenôtre de languettes, la tête demeurant annexée à son support correspondant et par le biais de l'intervention d'un élément qui réalise la fonction d'avance des languettes, les situe à l'endroit approprié où intervient un dispositif de coupe, une fois que la languette se trouve libérée de la bande métallique supérieure de soutien que configure le patenôtre et par l'intervention d'un poinçon situé dans la tête proprement dite, ce rapprochement préalable de la table de coordonnées, dans la partie supérieure de laquelle se trouve la plaque de circuit imprimé faisant l'objet de l'opération exécute l'insertion de la languette dans la plaque de circuit d'une façon entièrement automatique en un bref laps de temps.

Les têtes de ce type sont contrôlées par un automate programmable qui synchronise la tête, le mécanisme des languettes, le mécanisme de coupe et d'insertion, ainsi que le mouvement selon les axes X-X' et Y-Y' de la table de coordonnées. Les perfectionnements faisant l'objet de la présente invention visent à la simplification constructive de la tête, substituant les moyens hydrauliques ou pneumatiques de celle-ci par d'autres fonctionnant de manière entièrement mécanique et assurant une meilleure réponse, de moindres inerties de démarrage et d'arrêt, ainsi qu'une plus grande précision dans les courses ascendante et descendante de la tête, sur le circuit imprimé.

Étant donné la précision de l'opération d'insertion en soi, l'exactitude avec laquelle la tête, en descendant sur la plaque de circuit imprimé, oblige le poinçon correspondant à pousser la languette et la douille est d'une importance primordiale, car si elle descendait sans arriver au point souhaité du circuit imprimé, elle n'arriverait pas à enfoncer cette languette ou douille, et si au contraire la tête descendait au-dessous du point souhaité, soit le circuit imprimé se casserait, soit la languette ou douille elle-même se briserait ; ainsi, les mouvements de la tête doivent pouvoir être contrôlés avec exactitude et sans que celle-ci soit altérée par des heures et des heures de fonctionnement, motif pour lequel les moyens hydrauliques ou pneumatiques ont été remplacés par d'autres mécaniques, spécialement adaptés pour la fonction de la tête, aussi bien pour l'opération de rapprochement pour exécuter la fonction d'insertion que pour celle d'insertion proprement dite.

Pour exécuter pratiquement ces perfectionnements on a disposé latéralement au corps de la tête des engrenages qui s'engrènent entre eux et avec les corps intérieurs de la tête, de sorte que l'un des engrenages fait descendre le corps de la tête vers le bas, cependant qu'un autre lié au premier oblige le poinçon à descendre verticalement au travers de la conduite correspondante pour, en poussant la languette ou le terminal, l'insérer dans la plaque de circuit imprimé dûment placée sur le plateau de la table de coordonnées.

La combinaison des engrenages avec le corps de l'intérieur de la tête est obtenue en dotant la surface latérale de celui-ci de quelques pistes dentées qui permettent l'engrenage direct entre ces engrenages et le noyau ou partie intérieure de la tête, ce qui permet d'obtenir une parfaite précision et de pouvoir employer la même tête pour un autre type de circuit ou de machines à insérer où la distance entre la tête et la table de coordonnées serait différente ; il suffit ainsi de changer le rapport entre engrenages pour obtenir qu'une même tête puisse permettre d'exécuter des opérations distinctes sur des circuits imprimés également distincts ou des appareils d'insertion distincts.

D'autres détails et caractéristiques de l'actuelle patente d'invention seront soulignés au cours de la description qui est donnée ci-dessous, et qui fait référence aux figures accompagnant ce mémoire dans lequel, de façon quelque peu schématique, sont représentés les détails préférés. Ces détails sont donnés à titre d'exemple et se réfèrent à un cas possible de réalisation pratique, mais ne demeurent pas limités aux détails qui y sont exposés ; cette description doit donc être considérée d'un point de vue illustratif et sans aucune sorte de limitations.

Nous établirons ci-dessous les divers éléments numérotés sur les dessins joints au présent mémoire : (10) tête, (11) corps de (11), (12) base, (13) noyau intérieur, (14) surface dentée, (15) engrenage, (16) engrenage, (17) engrenage, (18) surface dentée, (19) support, (20) cylindre, (21) came, (21a) tête de (21), (22) glisseur, (23) tige, (24) fente, (26) vis, (27) conduite, (28) cylindre, (29) tige, (30) piston, (31) frein, (32) embouchure, (33) onglet d'entraînement, (34) circuit, (35) plateau, (36) axe de giration, (37) axe de giration, (38) corps intérieur, (39) poinçon, (40) patenôtre, (41) carcasse, (42) conduite d'aspiration, (43) onglet d'entraînement, (44) tête du piston (46), (45) tige, (46) piston, (47) conduite, (48) piston, (49) tige, (50) piston, (51) cliquet d'arrêt, (52) support, (53) levier, (54) piston, (55) tige, (56) conduite, (57) chariot porte-lames, (58) lame, (59) porte-lames.

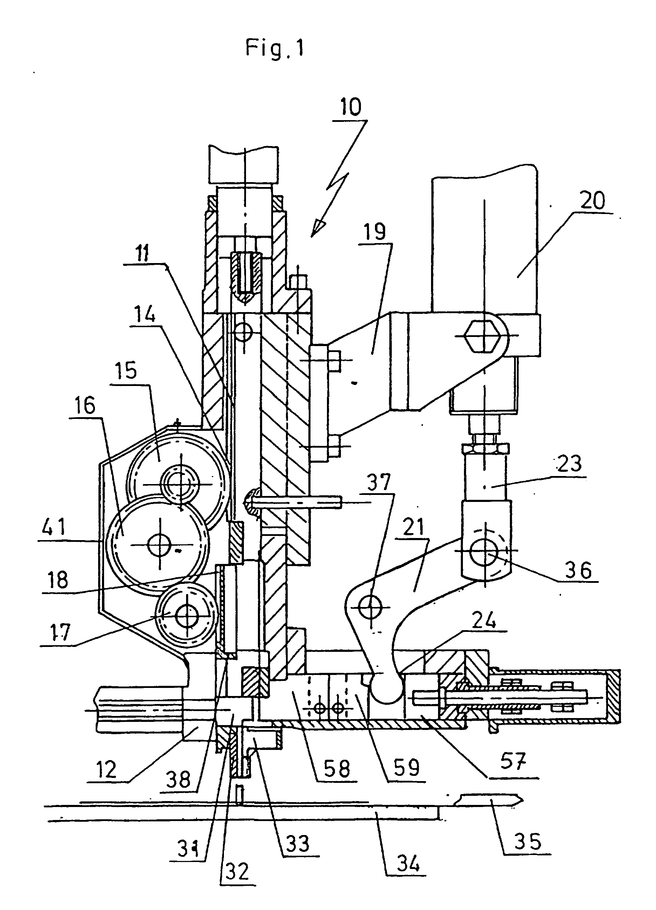

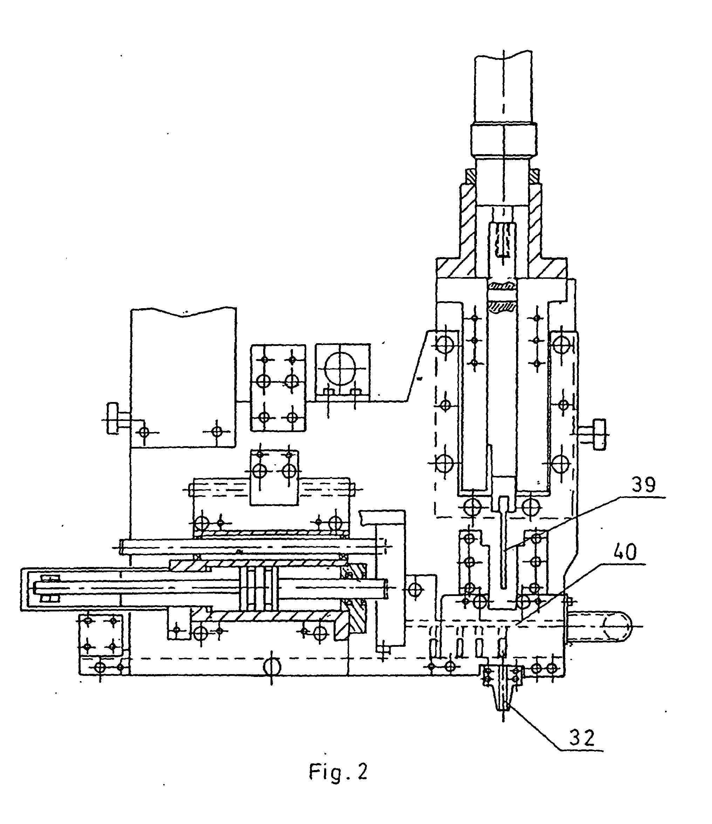

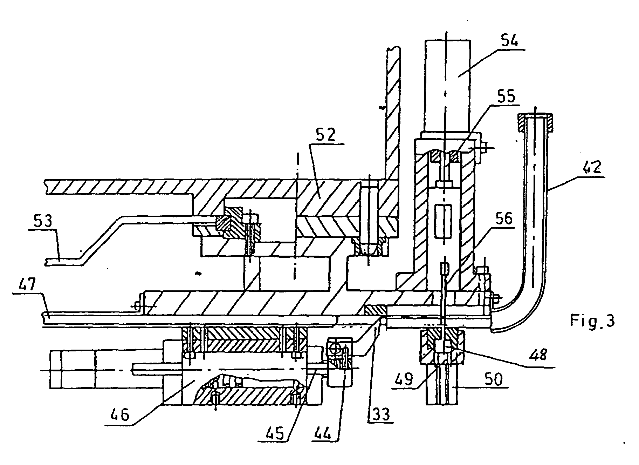

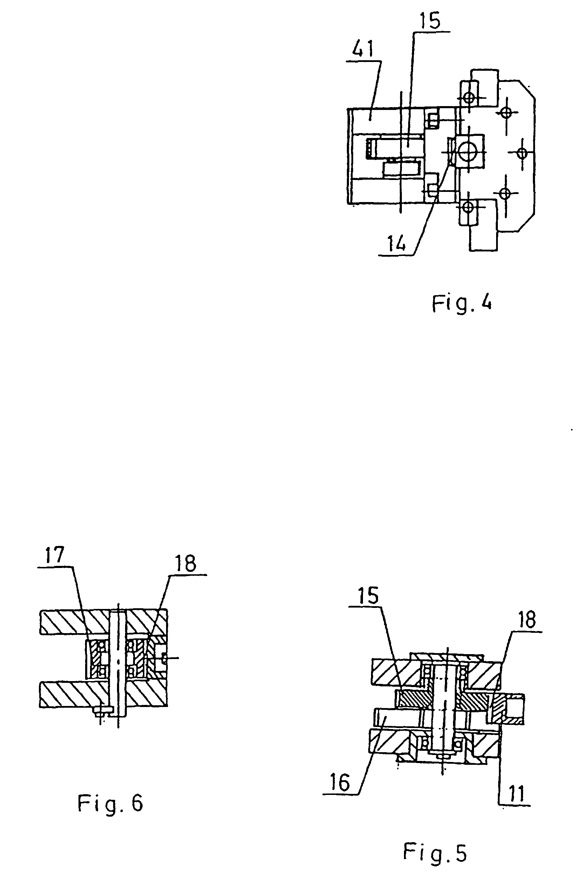

La figure nº 1 est une section longitudinale en élévation et schématisée de la tête (10) sur la partie gauche de laquelle on peut voir la carcasse (41) qui abrite en son intérieur les engrenages (15), (16) et (17) permettant les mouvements ascendants et descendants du poinçon et de la tête (10) proprement dite.

La figure nº 2 est une section longitudinale en élévation et schématisée de la tête perfectionnée (10) avec le système d'alimentation de douilles (31) fixées à la bande ou patenôtre (40) correspondant, les plaçant de telle sorte que le poinçon (39) puisse exécuter l'opération d'insertion.

La figure nº 3 est une section transversale en coupe schématisée de la tête perfectionnée (10) préconisée sur laquelle on peut voir le système d'entraînement du patenôtre de douilles (31) par le biais d'un onglet d'entraînement (33) monté sur un piston ou pneumatique (46).

La figure nº 4 est une vue supérieure en coupe et schématisée de la tête (10).

La figure nº 5 est une vue en coupe d'une section transversale et schématisée de la tête (10).

La figure nº 6 est une vue en coupe d'une section transversale schématisée de la tête (10).

Dans l'une des réalisations préférées de ce qui constitue l'objet de la présente sollicitude de patente d'invention et, comme le montrent les figures nº 1, 2 et 3, la tête est placée verticalement et est solidarisée à un support en cou de cygne (52) à l'aide d'un levier (53). Comme le montre la figure nº 3, le patenôtre de languettes ou douilles (31) avance par la conduite (47) jusqu'à ce qu'il se trouve à la verticale du poinçon (39); à ce moment-là, et par les moyens faisant l'objet de la présente patente d'invention se produit l'opération de rapprochement de la tête (10) et descente (39) par la conduite (56) lorsque, également par les moyens appropriés, les languettes ou douilles (31) de la bande ou patenôtre (40) qui les soutient ont été séparées, ces dernières n'étant pas représentées sur la figure nº 3.

L'une des missions de la tête (10), selon une formule connue, est d'arrêter le patenôtre (40) à un instant déterminé, de faire avancer les moyens d'immobilisation correspondants de celui-ci et de le séparer par coupure à l'aide des lames (58) correspondantes, la douille (31) de la bande correspondante, pour ensuite descendre la tête (10) et le poinçon (39), et insérer la douille (31) correspondante sur le circuit imprimé (34) situé sur le plateau (35), voir la figure nº 1.

La représentation qui est faite de la tête (10) sur les figures ci-jointes est une exécution pratique des moyens conventionnels employés pour les fonctions indiquées précédemment, sauf en ce qui concerne l'objet de l'invention, comme le montrent les figures nº 1, 4, 5 et 6 sur laquelle on peut voir une disposition de quelques engrenages (15), (16) et (17) d'axes parallèles, montés à l'intérieur d'une carcasse (41), et qui en combinaison avec une modification du corps (11) de la tête (10) et du corps intérieur de celle-ci, permettent les mouvements susmentionnés, mais exécutés d'une façon entièrement mécanique, une surface dentée (14) ayant été prévue à la surface du corps (11) de même que (18) dans le corps intérieur (38), de sorte que le premier a pour mission de rapprocher la tête (10) du circuit imprimé (34), le second permet la descente du poinçon (39) en descendant par la conduite de guidage (56), contraignant la douille (31) à sortir par l'embouchure (32) de (10), et à rester fixe sur le circuit (34), lorsque précédemment et à la manière conventionnelle et connue, le patenôtre ayant été retenu, la douille (31) étant solidement fixée par le piston (48), qui n'est pas représenté sur les figures, voir la figure nº 3, pour être ensuite séparée de (31), par coupure de la bande correspondante à l'aide des lames (58), celles-ci étant solidarisées au chariot porte-lames (57) poussé (57) à l'aide du cylindre (20), la tige (23) de celui-ci et la came (21) unissant (21) et (26) au travers de la goupille et de l'axe de giration (36), la tête (21a) étant introduite dans la rainure (24), (21) tournant sur l'axe (37) contraignant le porte-lames (57) à avancer et à rétrocéder alternativement, agissant chaque fois que le patenôtre (40) s'arrête et est immobilisé, coupant en deux lignes et libérant une douille (31).

Les possibilités de la nouvelle tête (10) sont essentiellement centrées sur le libre jeu et choix des engrenages (15), (16) et (17) dont les surfaces dentées sont en contact entre elles et celles de (15) et (17) avec les surfaces dentées (14) et (18) des corps (11) et (38) de la tête, voir la figure nº 1, ce qui fait que, comme cela a été commenté précédemment, l'on pourra changer avec une précision extraordinaire et en un minimum de temps le rapport d'engrenages (15), (16) et (17), et avec cela les courses de la tête (10) ; la première course de rapprochement de (10) et la seconde du poinçon (39) pourront être variées avec la plus grande aisance, sans nécessité de remplacer toute la tête (10) par une autre, en la séparant de son support (52), agissant sur le levier (53), avec la perte de temps conséquente, car il ne faut pas seulement séparer les parties mécaniques, mais également les unions électriques et électroniques.

Les possibilités des perfectionnements décrits présentent un deuxième avantage, celui de ne pas avoir à changer le reste de la machine, dont les moyens et leurs fonctions ont été succinctement décrites, pour illustrer sans les altérer, avec une même machine à insérer et en suivant le même procédé de travail, qu'il est possible en travaillant avec une même tête (10) d'exécuter la fonction d'insertion avec différents types de circuits imprimés (34).

La présente patente d'invention ayant été suffisamment décrite en correspondance avec les plans ci-joints, il est entendu que toutes modifications de détail jugées opportunes pourront être introduites sur ceux-ci, à la condition de ne pas altérer l'essence de la patente qui se trouve résumée dans la REVENDICATION suivante.

## Revendications

1. "CONSTRUCTION d'une TÊTE D'INSERTION DE LANGUETTES, DOUILLES ET SIMILAIRES", cette tête (10) étant dotée de moyens d'entraînement d'un patenôtre (40) de languettes, douilles (31) et similaires à base d'un onglet d'entraînement (33) qui oblige ledit patenôtre à avancer dans une conduite (47), demeurant immobilisé séquentiellement a l'aide d'un piston (48) monté sur une tige (49) et un cylindre (59), la tête étant dotée de moyens d'aspiration qui canalisent les copeaux de l'opération a travers une conduite (42) et avec des moyens de coupe formés d'un chariot porte-lames (57) et de lames (58) respectivement, actionné (57) par le biais d'un cylindre ou piston (20) qui actionne une tige (23) qui met la came (21) en relation avec le piston (20) et la tête de la came (21) avec le porte-lames (57) au travers de la rainure (24), permettant ainsi la séparation des languettes ou douilles (31) du patenôtre (40), **caractérisé par le fait que** la tête (10) camprend des moyens mécaniques qui permettent un premier rapprochement de la tête (10) vers une plaque de circuit imprimé (34) située sur un plateau giratoire (35) et celui-ci sur la table de coordonnées correspondante d'une machine à insérer et la descente ultérieure du poinçon (39) par une conduite (56) pour l'insertion de cette douille (31) dans ledit circuit (34), formés ces moyens mécaniques par des engrenages (15), (16) et (17), logés à l'intérieur d'une carcasse (41), dont les axes de rotation sont parallèles et engrènent l'engrenage (16) avec l'engrenage (16) et celui-ci avec l'engrenage (17) en même temps qu'elles engrènent avec les surfaces dentées (14) du corps (11) et les surfaces dentées (18) du corps intérieur (38), toutes deux de la tête (10).

## Patentansprüche

1. Aufbau eines Kopfes zur Einführung von Anschlussklemmen, Buchsen und Ähnlichen, wobei dieser Kopf (10) mit Mitteln zum Antreiben eines Buchsen- (31), Anschlussklemmenstreifens (40) oder Ähnliches mittels einer Antriebsgehrung (33), die den besagten Streifen zwingt in einer Leitung (47) fortzuschreiten, versehen ist, wobei dieser mit Hilfe eines Kolbens (48), der auf einem Schaft (49) und einem Zylinder (59) angeordnet ist, fortlaufend festgestellt wird, und wobei der Kopf mit Ansaugmitteln versehen ist, welche die Gräte des Vorganges über einer Leitung (42) lenken, sowie mit Schneidemitteln, die jeweils von einem Messer tragenden Schieber (57) und von Messern (58) gebildet werden, wobei dieser (57) durch die Ablenkung eines Zylinders oder Kolbens (20), der einen Schaft (23) antreibt, welcher den Nocken (21) in Bezug auf den Kolben (20) und den Nockenkopf (21) mit dem Messerträger (57) durch die Nut (24) versetzt, angetrieben wird, wobei auf diese Weise die Trennung der Anschlussklemmen oder Buchsen (31) des Streifens (40) ermöglicht wird, **dadurch gekennzeichnet, dass** der Kopf (10) mechanische Mittel umfasst, die eine erste Annäherung des Kopfes (10) an einer Platte (34) mit gedruckter Schaltung, die auf einer drehbaren Scheibe (35) angeordnet ist, die sich auf den entsprechenden Koordinatentisch einer Einführungsmaschine befindet, ermöglicht, sowie die abschließende Abwärtsbewegung des Stempels (39) durch eine Leitung (56) zur Einführung dieser Buchse (31) in der besagten Schaltung, wobei diese mechanische Mittel aus Getrieben (15), (16) und (17) bestehen, die im Inneren eines Gehäuses (41) eingebaut sind und deren Drehachsen parallel zueinander sind, wobei das Getriebe (16) das Getriebe (16) und dieses seinerseits das Getriebe (17) eingreift und gleichzeitig die verzahnten Flächen (14) des Körpers (11) und die verzahnten Flächen (18) des inneren Körpers (38), beide des Kopfes (10), eingegriffen werden.

## Claims

1. A construction of an insertion head of connection terminals, sockets and the like, this head (10) being provided with means for actuating a strip (40) of connection terminals, sockets (31) and the like by means of an actuation burin (33) which forces said strip to move forward in a conduit (47), being sequentially immobilized with the aid of a piston (48) assembled on a rod (49) and a cylinder (59), the head being provided with aspiration means channeling the burrs from the operation through a conduit (42) and with cutting means formed of a blade-holding carriage (57) and of blades (58), respectively, actuated (57) by the shifting of a cylinder or piston (20) actuating a rod (23) which situates the cam (21) in relation to the piston (20) and the head of the cam (21) with the blade-holder (57) through the groove (24), thus enabling the separation of the connection terminals or sockets (31) from the strip (40), **characterized by** the fact that the head (10) comprises mechanical means enabling a first approaching of the head (10) towards a printed circuit board(40) situated on a rotating disk (35), and the latter on the corresponding coordinate table of an insertion machine, and the final downward movement of the punch (39) through a conduit (56) for the insertion of this socket (31) in said circuit (34), these mechanical means being formed by gears (15), (16) and (17) housed inside a casing (41), the rotating shafts of which are parallel and engage gear (16) with gear (16) and the latter with gear (17), while at the same time they engage with the toothed surfaces (14) of the body (11) and the toothed surfaces (18) of the inner body (38), both of the head (10).
